(19)
Europäisches Patentamt

European Patent Office

Office européen des brevets

(11) **EP 2 776 607 B1**

(12) **EUROPEAN PATENT SPECIFICATION**

(45) Date of publication and mention
of the grant of the patent:
**23.08.2017 Bulletin 2017/34**

(21) Application number: **12805786.6**

(22) Date of filing: **01.11.2012**

(51) Int Cl.:
*C25B 11/03* (2006.01)     *C25B 11/04* (2006.01)
*C25C 7/02* (2006.01)      *C25D 17/10* (2006.01)

(86) International application number:
**PCT/JP2012/078904**

(87) International publication number:
**WO 2013/069711 (16.05.2013 Gazette 2013/20)**

(54) **MANUFACTURING METHOD FOR AN ELECTRODE FOR ELECTROCHEMISTRY**

HERSTELLUNGSVERFAHREN FÜR EINE ELEKTRODE FÜR ELEKTROCHEMIE

PROCÉDÉ DE FABRICATION D'UN ÉLECTRODE POUR ÉLECTROCHIMIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.11.2011 JP 2011245987**

(43) Date of publication of application:
**17.09.2014 Bulletin 2014/38**

(73) Proprietors:
• **Shinshu University
Matsumoto-shi, Nagano 390-8621 (JP)**
• **De Nora Permelec Ltd
Fujisawa-shi
Kanagawa 252-0816 (JP)**

(72) Inventors:
• **SUGIMOTO, Wataru
Ueda-shi
Nagano 386-8567 (JP)**
• **ZHANG, Junfeng
Ueda-shi
Nagano 386-8567 (JP)**

(74) Representative: **Blodig, Wolfgang
Wächtershäuser & Hartz
Patentanwaltspartnerschaft mbB
Weinstrasse 8
80333 München (DE)**

(56) References cited:
**US-A- 4 957 591      US-A- 5 844 252
US-A1- 2011 226 616   US-B1- 6 348 240**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Field of the Invention**

The present invention relates to a manufacturing method of an electrode for electrochemistry having a high quality conductive diamond layer with a controlled crystal plane capable of effectively performing expected electrochemical reaction. The present invention relates to a manufacturing method of an electrode for electrochemistry with a high durability and a long-standing stability serviceable in electrolysis, and the manufacturing method for the same; more in detail, it relates to the electrode for electrochemistry for plating, metal electrowinning, etc. with a high durability, especially serviceable in a strong acidic solution for high speed galvanizing, electrolytic copper foil production, etc. under a high current density, and capable of avoiding impurities onto the formed metals, produced plating layer or copper foil.

**Background of the Invention**

Electrolysis process is able to generate hydrogen, oxygen, ozone, hydrogen peroxide, etc. by applying clean electric energy on an electrode surface through controlling chemical reactions, if it is aqueous solution system, which is a basic technology widely applied in the area of industrial electrolyses including brine electrolysis, electrolytic plating and metal extraction. Nowadays, the process has been also utilized for waste water treatment, which can decompose organic pollutants indirectly or can adsorb them on the electrode to electrolyze directly.

It is known that in the oxidation reaction at the anode in electrolysis, oxidizing agent effective for water treatment (such as available chlorine and ozone) is formed and also partially, active species including OH radical evolve. Waters including them are commonly used, under the name of active water, functional water, ion water, sterilizing water, etc. Thus, electrolysis process is utilized; however, it is indicated that depending on the applied electrode material, aimed reactions do not proceed as expected. Generally speaking, in the anode oxidation reaction at electrolysis in aqueous solution, electrolysis product is formed for which water is raw material. It often happens, however, that oxidation of other coexistence materials will not easily proceed in case of electrode catalyst with a high reactivity to electric discharge of water.

Materials for the electrode (anode) for electrolysis which performs oxidation include lead oxide, tin oxide, platinum group metal and oxides thereof and carbon. Whereas, materials for the electrode substrate need to have corrosion resistance in view of long service life and avoidance of contamination to the treatment surface. Materials for anode substrate are limited to valve metals such as titanium and alloys thereof, and also, materials for electrode catalyst are limited to precious metals such as platinum, iridium and oxides thereof. However, it is known that these expensive materials consume themselves depending on input current density and with lapse of time, resulting in flow into the solution. Accordingly, electrodes more superior in corrosion resistance is required. Conventionally applied graphite or amorphous carbon materials consume themselves, especially significant when used as anode.

On the contrary, diamond, which is superior in thermal conductivity, optical permeability and durability to high temperature and oxidation with an additional advantage of availability for controlling electrical conductivity by doping has been regarded as promising as semiconductor device and energy conversion element. PTL 1 discloses an application, as a sensor, of a diamond electrode with electrical conductivity provided by ion-doping.

Swain, et al. reports the stability of diamond in acidic electrolyte and suggests that diamond is far superior as electrode for electrochemistry compared with other carbon materials (NPL 1). Basic electrochemical properties are opened in detail in NPL2.

PTL 2 suggests that organic waste water can be decomposed by using diamond as anode material. PTL 3 proposes a method to treat organic substance electrochemically applying conductive diamond as anode and cathode. PTL 4 proposes a method for water treatment applying a conductive diamond electrode as anode and a gas diffusion electrode for hydrogen peroxide generation as cathode.

Industrial application in case of high current density and high potential region has not been reported adequately. PTL 5 reports that diamond electrode is inactive to decomposition reaction of water and that ozone is formed in oxidation reaction in addition to oxygen. PTL 6 discloses application of diamond electrode in molten salt electrolysis.

In the electrolysis process applying diamond as electrode for electrolysis, it is known that reaction efficiency is improved compared with conventional electrodes, but depending on the application areas, the service life is too short to meet the purpose.

As the reasons, it is presumed that active spots of diamond surface is small in existence density compared with other electrode materials and the geometric form also is smooth (only 1/100 compared with the electrochemical double layer capacitance of platinum electrode) and therefore, actual current density increases than the applied current density, easily leading to electrode erosion by electrolysis.

Recently, a manufacturing method of diamond electrode has been developed, in which the diamond surface provided with porous masking material is etched with oxygen plasma to provide pores of several 10nm and to make honeycomb shape of an approx.100nm pitch (several $1\mu$m in depth), depending on masking specification (NPL 3). Also reported is the technology to form catalyst of other materials including platinum on it (NPL 4).

However, it was difficult to apply this process to industrial electrodes, and also difficult to obtain finer pore quality. Under such circumstances, it has been necessary to develop a porous diamond electrode to be utilized in the industrial electrolyses.

PTL 7 discloses a manufacturing method of a diamond electrode with higher electrode activity having a larger number of microporosity than the conventional diamond electrode. Micropore is formed on the surface of the diamond layer in such manner that metal particle deposited on the diamond layer coated on the substrate surface is heat-treated in a reducing gas atmosphere to expedite carbon reduction reaction in which the metal functions as catalyst. Diamond layer or diamond particle with micropore formed at an atomic level or the level near to it is obtained because the metal particle deposited on the surface of the diamond layer is utilized. The microporosity increases surface area of diamond layer, which is catalyst, leading to improving catalyst activity. This method, however, requires metal particles to be deposited on the surface of diamond layer by such processes as the vapor deposition method and to be heat-treated in a reducing gas atmosphere.

On the other hand, for the EGL (Electro Galvanizing Line) represented by a high speed galvanizing and electrolytic copper foil production, the metal electrode, DSE (registered trademark of Permelec Electrode Ltd.), in which platinum group metal or its oxide is coated on the surface of valve metals, such as titanium is applied.

DSE shows remarkably superior stability in comparison with other electrodes and widely used for its no mingling of impurity in formed metal and high quality. This dimensionally stable electrode is used in brine electrolysis and is known to show superior stability. However, if it is used in a plating bath, etc., oxidation corrosion of titanium which is the substrate proceeds and electrolysis stops in spite that the coating layer of platinum group metal oxide still remains. Some measures are necessary to cope with this situation. For instance, PTL 8 and PTL 9 disclose that an intermediate layer of metals, such as tantalum or its alloys is formed between the substrate and the electrode active substance to improve durability of the electrode.

PTL 10 discloses a technology that a diamond layer is formed first on the substrate as an intermediate layer, and then platinum group metal catalyst is formed. This diamond intermediate layer, however, has a structure smoothly deposited. When catalyst is formed on this diamond intermediate layer, more in particular when the catalyst layer is formed by coating precursor solution of catalyst raw material on the substrate, followed by heat-treatment, coating of catalyst is difficult since suitable anchor has not been formed and coated catalyst easily falls off. Practical application was not realized.

PTL 11 discloses that electrode catalyst for electrochemical reaction is prepared in such a manner that a lot of conductive diamond particles loaded with carbon reactive catalyst metal in the micropore formed on the surface of the diamond particles is mixed with binder. This catalyst is available for air electrode or fuel electrode of a fuel cell. Metal catalyst loaded in micropore shows a higher stability of catalyst (suppression of coagulation, prevention to falling off) than metal catalyst loaded on the surface of particles, and can achieve high activation and long-standing life with a small amount of metal and can reduce usage of expensive metal. PTL 11 discloses a technology to form catalyst on diamond particles, but there is no description about the application to the electrode for a large scale industrial electrolysis.

Recently, the manufacturing method of porous diamond electrode by steam-activation process has been reported in NPL 5 and PTL 12. In this method, diamond electrode with microporosity can be manufactured without removing the catalyst metal as afore-mentioned and at the same time, graphite-like carbon present in the diamond layer is selectively vanished, achieving an electrode with high quality.

However, this method cannot manufacture a conductive diamond layer with high quality and controlled crystal plane.

Furthermore, by the conventional diamond porosity processing, several kinds of crystal plane still remain mixed, like the surface of un-treated. Electrochemical properties are considered to be largely relied on the crystal plane exposed on the electrode surface. Controlling the crystal plane, however, is difficult and the industrial manufacturing methods have not been found.

**Literature of Related Prior Art**

**Patent Literature**

PTL 1: JP58-160860A
PTL 2: JP07-299467A
PTL 3: JP2000-226682A
PTL 4: JP2000-254650A

PTL 5: JP11-269685A
PTL 6: JP3893397B
PTL 7: JP2006-183102A
PTL 8: JP2761751B
PTL 9: JP2574699B
PTL 10: JP09-279398A
PTL 11: JP2007-242433A
PTL 12: JP2011-184749A

**Non-Patent Literature**

NPL 1: Journal of Electrochemical Society, Vol.141, 3382(1994)
NPL 2: Electrochemistry, Vol.67, No.4, 389(1999)
NPL 3: Adv. Mater., 6,444(2000)
NPL4: J. Electroanal. Chem., 514, 35 (2001)
NPL 5: Electrochimica Acta, 2011, 56, 5599 (2011)

**Summary of the Invention**

**Problems to be solved by the invention**

Having solved the above-mentioned conventional technical problems, the present invention, has found that diamond component is partially removed through oxidation in a high temperature and in carbon dioxide, and a fine porous layer is formed, by which aiming to provide a diamond electrode of high quality with controlled crystal plane and a manufacturing method for the same.

**Means for solving the problem**

As the solution to solve the above-mentioned problem, the present invention provides a manufacturing method for an electrode for electrochemistry according to claim 1. In the manufacturing method for the electrode for electrochemistry with a polycrystalline conductive diamond layer formed on the electrode substrate, the electrode substrate with the formed polycrystalline conductive diamond layer is held under an atmosphere of carbon dioxide at a temperature 400 degrees Celsius or higher but 1000 degrees Celsius or lower to make micropore with (100) plane as main constituent remain and be formed in the polycrystalline conductive diamond layer. The present application provides a manufacturing method for an electrode for electrochemistry, wherein a catalyst layer of electrode substance comprising platinum group metal and/or its oxides is formed in and on the polycrystalline conductive diamond layer with the micropore remaining or formed. The present application provides a manufacturing method for an electrode for electrochemistry, wherein the electrode substrate is made from carbon or valve metal selected from among titanium, tantalum and niobium. The present application provides a manufacturing method for an electrode for electrochemistry, wherein the typical diameter of the micropore is 1 nm or longer but 1$\mu$m or shorter. The present application provides a manufacturing method of particles for an electrode for electrochemistry, characterized in that polycrystalline conductive diamond particles are held under an atmosphere of carbon dioxide at a temperature 400 degrees Celsius or higher but 1000 degrees Celsius or lower to make micropore with (100) plane as main constituent remain and be formed in the polycrystalline conductive diamond particles. The present application provides an electrode for electrochemistry, characterized in that the electrode substrate with the formed polycrystalline conductive diamond layer is held under an atmosphere of carbon dioxide at a temperature 400 degrees Celsius or higher but 1000 degrees Celsius or lower to make micropore with (100) plane as main constituent remain and be formed in the polycrystalline conductive diamond layer. The present application provides an electrode for electrochemistry, characterized in that the electrode substrate with the formed polycrystalline conductive diamond layer is held under an atmosphere of carbon dioxide at a temperature 400 degrees Celsius or higher but 1000 degrees Celsius or lower to make micropore with (100) plane as main constituent remain and be formed to provide a catalyst layer of electrode material on the polycrystalline conductive diamond layer.

**Advantageous Effect of the Invention**

The present invention can construct a porous polycrystalline conductive diamond layer with controlled crystal plane which has a large surface area. An electrode for electrochemistry having such layer can achieve high quality, increased reaction efficiency and stability. Moreover, the treatment can be carried out under an atmosphere of carbon dioxide at a high temperature and therefore, manpower and cost can be significantly reduced compared with the conventional treatment.

Moreover, the construction of the electrode for electrochemistry with the catalyst layer of the electrode substance in and on the polycrystalline conductive diamond layer, that is, the construction in which an intermediate layer comprising high quality substance of conductive diamond structure with micropore is formed between the electrode substrate and the catalyst layer can provide stable electrolysis performance for a long time, because the catalyst layer strongly adheres to the intermediate layer from the anchor effect of the micropore and sufficient corrosion resistance is given even for electrolytic operation under corrosive atmosphere.

In addition, economy improves because actual current density decreases by increase in electrode surface area, leading to low overvoltage. Use of the electrode by the present invention is not limited to the electrolysis areas. It can be applied not only for electrolytic synthesis, but also as an electrode for electrochemical analysis for its high sensitivity. The manufacturing process by the present invention can be applied to a large scale electrode, remarkably contributing to high productivity.

## Brief Description of the Drawings

[Fig. 1] Fig. 1 shows a photograph of the diamond layer without the carbon dioxide treatment by the high-resolution scanning electron microscope.

[Fig. 2] Fig. 2 shows a photograph of the polycrystalline conductive diamond layer with the carbon dioxide treatment in Example 1 by the high-resolution scanning electron microscope. (800 degrees Celsius for 4 hours)

[Fig. 3] Fig. 3 shows a photograph of the polycrystalline conductive diamond layer with the carbon dioxide treatment in Example 2 by the high-resolution scanning electron microscope. (900 degrees Celsius for 4 hours)

[Fig. 4] Fig. 4 shows a graph of the Raman spectrometry of the diamond layer without the carbon dioxide treatment (line a), the diamond layer with the treatment by Example 1 (line b) and the diamond layer with the treatment by Example 2 (line c). The peak around $1300 cm^{-1}$ represents the presence of diamond component.

[Fig. 5(a)] Fig. 5(a) shows graph of the electrochemical measurements, which is the cyclic voltammogram at 100mV/s in 0.1 M sodium sulfate containing 1 mM ferri-/ferrocyanide ion couple of the polycrystalline conductive diamond layer without the carbon dioxide treatment.

[Fig. 5(b)] Fig. 5(b) shows graph of the electrochemical measurements, which is the cyclic voltammogram at 100mV/s in 0.1 M sodium sulfate containing 1 mM ferri-/ferrocyanide ion couple of the polycrystalline conductive diamond layer with the carbon dioxide treatment by Example 1.

[Fig. 6] Fig. 6 shows a graph giving polarization characteristics of the diamond layer without the carbon dioxide treatment (line a), the polycrystalline conductive diamond layer treated by Example 1 (line b) and the polycrystalline conductive diamond layer treated by Example 2 (line c).

[Fig. 7] Fig. 7 shows a graph giving electrochemical measurements, which is cyclic voltammogram at 100mV/s in 0.1 M sodium sulfate, of the diamond layer without the carbon dioxide treatment (line a), the polycrystalline conductive diamond layer treated by Example 1 (line b) and the polycrystalline conductive diamond layer treated by Example 2 (line c).

## Best Mode for Carrying out the Invention

The following explains, in detail, the electrode for electrochemistry proposed by the present application in reference to drawings.

The electrode for electrochemistry can be desirably applied, the use of which is not limited in particular, in various electrolyses including various plating processes, such as high speed galvanizing, metal electrowinning like electrolytic copper foil production, brine electrolysis, organic electrolysis, ozone production, water treatment, molten salt electrolysis, fuel cells, and sensors.

The electrode for electrochemistry comprises the electrode for electrochemistry comprising the substrate and the polycrystalline conductive diamond layer with micropore coated on the surface of electrode substrate, and the electrode for electrochemistry comprising the substrate, the polycrystalline conductive diamond layer with micropore coated on the surface of the electrode substrate, and the catalyst layer of electrode substance having platinum group metal and/or its oxide formed in and on the polycrystalline conductive diamond layer.

As the material for the electrode substrate, titanium, niobium, tantalum, silicon, carbon, etc. are chosen and processed to a state of particle, fiber, plate, punched plate, metal mesh, powder-sintered body, metal fiber sintered material, etc. The electrode substrate may also serve as a current collector. When the electrode for electrochemistry is utilized as an electrode for electrolytic oxidation applying electrolyte containing corrosive component, niobium or tantalum, which is superior in corrosion resistance is desirable to be used as the material for the electrode substrate. It is also possible that the electrode substrate is made of titanium and corrosion-resistant niobium or tantalum is coated on the surface of the substrate, constituting an electrode substrate of composite material.

The polycrystalline conductive diamond (intermediate) layer is formed by directly coating the surface of electrode substrate with the electrode substance of conductive diamond structure. It is preferable that the surface of electrode substrate is roughened to improve adherence between the substance of the conductive diamond structure of the polycrystalline conductive diamond layer and the electrode substrate and also to decrease actual current density. It is also preferable that the surface area is increased by using #20 alumina grit, in case of use under a high current density, and the surface is roughened by using #60-120 fine alumina sand in case of use under corrosive condition at relatively a low current density to enhance adherence of diamond coating.

Thus, grinding the surface of electrode substrate of niobium, etc. is desirable for an increase in adherence. At this time, if diamond powder is used, it adds to the electrode substrate as nucleus or it functions as flawing treatment, leading to developing uniform diamond (intermediate) layer.

The material of polycrystalline conductive diamond layer in the method of the present invention is diamond to which boron as an impurity is doped to give conductivity. Material with a trace amount of graphite partially coexistent in the diamond structure is also partially applicable.

Diamond alone does not have conductivity, and therefore a desirable conductive diamond is prepared usually in such a manner as afore-mentioned that impurity is added to organic compound as raw material and the organic compound together with mixed impurity is adhered on the electrode substrate. As impurity, a simple substance consisting of boron or a compound containing it e.g., powder boric acid (boron oxide) or diphosphorus pentoxide is applicable. Other than them, diborane ($B_2H_6$) or phosphine ($PH_3$) is applicable as the impurity, but because these are strongly toxic, afore-mentioned powder boric acid and diphosphorus pentoxide are desirable. The content of the impurity is preferably 1 ppm or greater but 10000 ppm or less, more preferably 100 ppm or greater but 1000 ppm or less. The resistivity is controllable 100Ωcm or less 0.1Ωcm or higher.

As the formation method of the diamond layer, such methods have been developed as hot filament CVD, microwave plasma CVD, plasma arc jet, and PVD. To obtain a powder, ultra-high-pressure synthetic diamond powder (HPHT) process and plasma arc jet process are used as conventionally applied.

The following describes a typical hot filament CVD method.

The reaction system internal is under hydrogen stream. As the carbon source, $CH_4$, $CH_3OH$, etc. are supplied, but any material can be used without limitation as long as it is a gasifiable organic compound. The gas concentration of organic compound to hydrogen is preferably in the range of 0.1-5 vol.%, and the pressure within the system is preferably 0.002 MPa or higher but 0.1 MPa or lower.

The material for the reaction system should be resistant to the atmosphere of hydrogen and high temperatures. While the filament temperature is controlled to 1800 degrees Celsius or higher but 2600 degrees Celsius or lower at which carbon radicals evolve, the electrode substrate is disposed in a temperature region at which diamond deposits (650-950 degrees Celsius). The material for filament is preferably tantalum, tungsten, etc.

The porosity processing for the polycrystalline conductive diamond layer is carried out by heating 400 degrees Celsius or higher but 1000 degrees Celsius or lower under carbon dioxide atmosphere.

The reduction reaction of diamond carbon by carbon dioxide is considered to proceed as follows.

$$C + CO_2 = 2CO$$

As reaction condition, carbon dioxide is supplied to the reaction system at atmospheric pressure of 0.1 MPa. Micropore increases or decreases depending on time. Usually, 1-10 hours' processing is preferable. The temperature is 400 degrees Celsius, or higher but 1000 degrees Celsius or lower. With increasing temperature, remaining of (100) plane becomes significant, resulting in high quality, but if it is too high, all diamond will decompose.

The representative diameter of micropore can be controlled 1 nm or longer but 1μm or shorter by selecting conditions. If the pore diameter is less than 1 nm, electrolyte cannot penetrate, and then, a significant improvement effect cannot be obtained with respect to its application to electrochemistry. Moreover, penetration of the solution containing the precursor catalyst to be described later in the specifications is limited and catalyst is less likely to be formed. On the other hand, it is possible to form a larger pore than 1μm, but in that case, there is no practical significance to use the present invention because the crystal dimension of the diamond layer to form micropore is 1μm or longer but 10μm or shorter. If the depth of pore is deeper than 10μm, some parts that do not contribute to the electrochemical reaction effectively may be formed depending on the ratio to the pore diameter and may cause a decrease in mechanical strength.

In addition, it is also preferable that the multi-pore diamond is subject to oxidation treatment to make the surface to be oxygen-terminated and thus, the bonding with the thermally decomposed oxide to be described later in the specifications is improved.

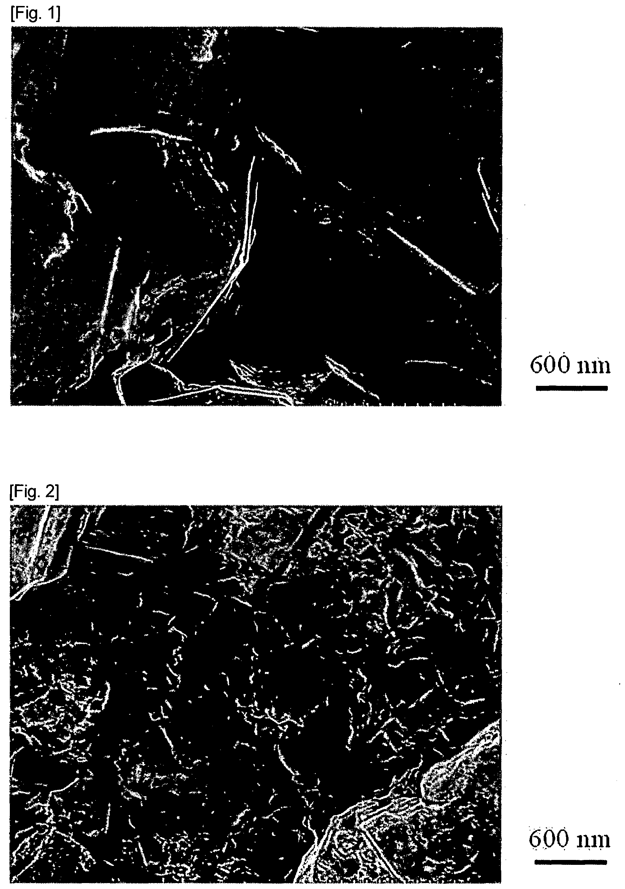

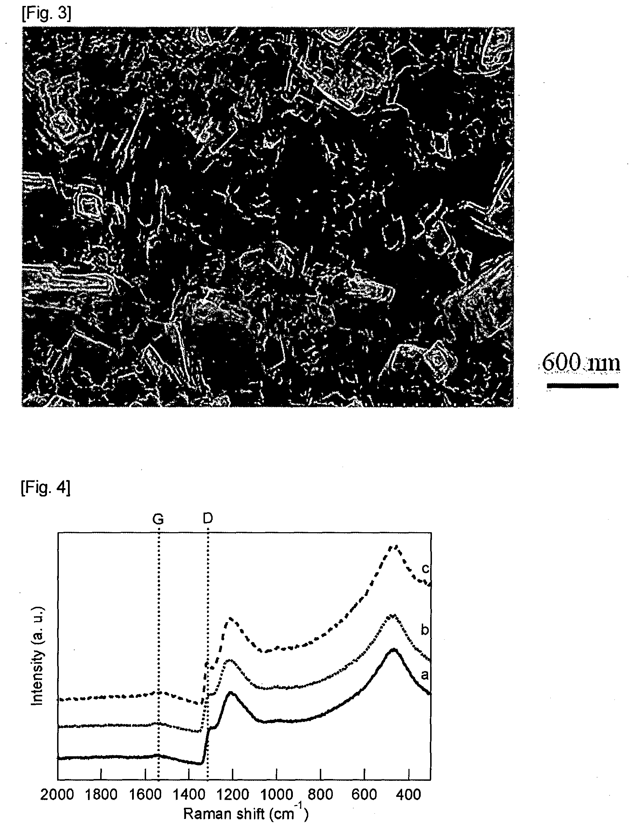

Fig. 1 is a photograph by the electron microscope showing the state of untreated polycrystalline conductive diamond doped with boron to the surface of niobium substrate. Fig. 2 is a photograph by the electron microscope showing the polycrystalline conductive diamond with micropore prepared by the treatment method of Example 1, in which the polycrystalline conductive diamond doped with boron on the surface of niobium substrate is treated at 800 degrees Celsius for 4 hours while carbon dioxide is being supplied at a rate of 0.2 Umin. Fig. 3 is a photograph by the electron microscope showing the polycrystalline conductive diamond with micropore prepared by the treatment method of Example 2, in which the polycrystalline conductive diamond doped with boron on the surface of niobium substrate is treated at 900 degrees Celsius for 4 hours while carbon dioxide is being supplied at a rate of 0.2 Umin. Figs. 2 and 3 show innumerable numbers of micropores formed on the electrode, while no micropore exists on the untreated electrode shown in Fig. 1.

Thus, the present invention carries out porosity preparation for the polycrystalline conductive diamond layer by heating under an atmosphere of carbon dioxide. However, if other methods are combined, porosity preparation for polycrystalline conductive diamond layer will be achieved further efficiently.

For example, if such metal particles as cobalt, iron, nickel, titanium, tantalum, ruthenium, platinum, niobium, molybdenum, tungsten, and those alloys are attached on the surface by vapor deposition or a thermal decomposition simultaneously with or after formation of the polycrystalline conductive diamond layer, the metal particles function as catalyst and promote carbon reduction reaction (e.g. methanongenic reaction) between the polycrystalline conductive diamond layer and hydrogen to make the surface of the polycrystalline conductive diamond layer porous. When this method of pore preparation by metal particles is combined, the polycrystalline conductive diamond layer with a higher degree of pore formation is obtained compared with a single method for pore formation.

The electrode with the polycrystalline conductive diamond layer thus manufactured can be applied for various applications as electrode for electrochemistry in which the polycrystalline conductive diamond layer functions as catalyst. However, if an electrode substance layer of metal or metal oxide is coated on the surface of the polycrystalline conductive diamond layer, an electrode for electrochemistry with a higher performance can be provided.

Selection of applicable electrode substance may depend on the application of the electrode for electrochemistry. Even if durability is inferior to some extent, stable electrolysis operation is available for a long time, because intrusion of electrolyte or oxygen is suppressed by the intermediate layer having material of the conductive diamond structure. However, naturally, it is desirable to use electrode material having durability. Preferable is the use of electrode substances composed primarily of platinum group metal such as platinum, palladium, iridium, ruthenium and rhodium and their oxides, e.g., a complex oxide of iridium oxide and tantalum oxide. This electrode substance can be coated on the surface of the intermediate layer by a commonly used thermal decomposition method; for example, mixture solution of iridium chloride and butyl tantarate, as coating solution, is coated on the surface of the intermediate layer, followed by drying and thermal decomposition to obtain electrode substance of the quantity of wish by repeating these operations. Desirable repeating time is 3-30 times.

The carbon dioxide treatment by the present application is applicable to particle-formed polycrystalline conductive diamond and obtained particles can be used as a fluid bed or a fixed bed as it is, or can be used in a state of sheet molded with resin.

The following describes examples relate to the electrode for electrochemistry and the manufacturing method for the same. Provided, however, these examples do not limit the present invention at all.

**Examples**

[Example 1]

Using a niobium plate of 2mm thick, 2cm x 2cm as an electrode substrate, diamond is directly deposited using a hot filament CVD system under the conditions to be mentioned. The surface of electrode substrate was polished with abrasives consisting of diamond fine particles ($3\mu$m diameter) for activation of the surface and nuclear attachment. The substrate was installed to the hot filament CVD system. Ethyl alcohol was used for a carbon source in which boron oxide was dissolved at the concentration of 2500 ppm. Hydrogen gas was supplied at 0.1 Umin, part of which was bi-passed to the carbon source container. The concentration of ethyl alcohol gas to hydrogen was 0.5 vol.%. While these gases were being supplied to the system, electric current was provided to the filament and the temperature was raised to 2200 degrees Celsius or higher but 2400 degrees Celsius or lower at which carbon radicals generate. The temperature of the electrode substrate directly beneath the filament was measured to be 800 degrees Celsius. After 3 hours' CVD operation, the electrode substrate was taken out.

Thus prepared diamond electrode of $5\mu$m thick doped with boron at 2500 ppm was treated for 4 hours at 800 degrees Celsius, while carbon dioxide was being supplied at a rate of 0.2 Umin. to form micropore on the electrode surface.

Fig. 2 shows a photograph of the polycrystalline conductive diamond layer by high-resolution scanning electron microscope. In the diamond treated at 800 degrees Celsius, pit of 0.1-0.2$\mu$m order and crystal finer than 0.5$\mu$m order were generated, while the structural plane of square (tetragonal system) remained and was formed.

[Example 2]

The diamond electrode of 5$\mu$m thick prepared in the same manner as with Example 1 was treated at 0.1 MPa for 4 hours at 900 degrees Celsius, while carbon dioxide was being supplied at a rate of 0.2 Umin. to form micropore on the electrode surface.

Fig. 3 shows a photograph of the polycrystalline conductive diamond layer by high-resolution scanning electron microscope, treated by the method described in Example 2. From the photograph, the plate-like structure mainly of (100) orientation is observed and it is confirmed that the carbon of (111) structure were selectively consumed. Micropores of 0.1$\mu$m or longer but 1$\mu$m shorter diameter were formed on the electrode surface.

Fig. 4 is the Raman spectrometry of the diamond layer showing before and after the carbon dioxide treatment. Line a shows the diamond layer without carbon dioxide treatment; Line b shows the diamond layer treated by the method described in Example 1, in which the polycrystalline conductive diamond doped with boron on the surface of niobium substrate was treated for 4 hours at 800 degrees Celsius, while carbon dioxide is being supplied at a rate of 0.2 L/min.; and Line c shows the diamond layer treated by the method described in Example 2, in which the polycrystalline conductive diamond doped with boron on the surface of niobium substrate was treated for 4 hours at 900 degrees Celsius, while carbon dioxide is being supplied at a rate of 0.2 L/min.

As clear from Fig. 4, the Raman spectra of the diamond electrode after carbon dioxide treatment (Line b and Line c) have the increased ratio, D/G (Diamond/Graphite) in which (D) is the peak attributable to diamond of around 1300 cm$^{-1}$ and (G) is the band attributable to sp$^2$ carbon around 1500 cm$^{-1}$, compared with the Raman spectrum of the diamond electrode before the carbon dioxide treatment (Line a). In addition, the peak at 1310 cm$^{-1}$ shifted to 1318 cm$^{-1}$ in the treatment at 900 degrees Celsius by Example 2 as shown by Line c, suggesting change to the diamond with a smaller concentration of boron. The concentration of boron of (100) plane is known to become smaller than that of (111) plane (Diamond Rel. Mater, 7, 1719 (1998)), suggesting accord with increase in (100) plane in the photograph by electron microscope.

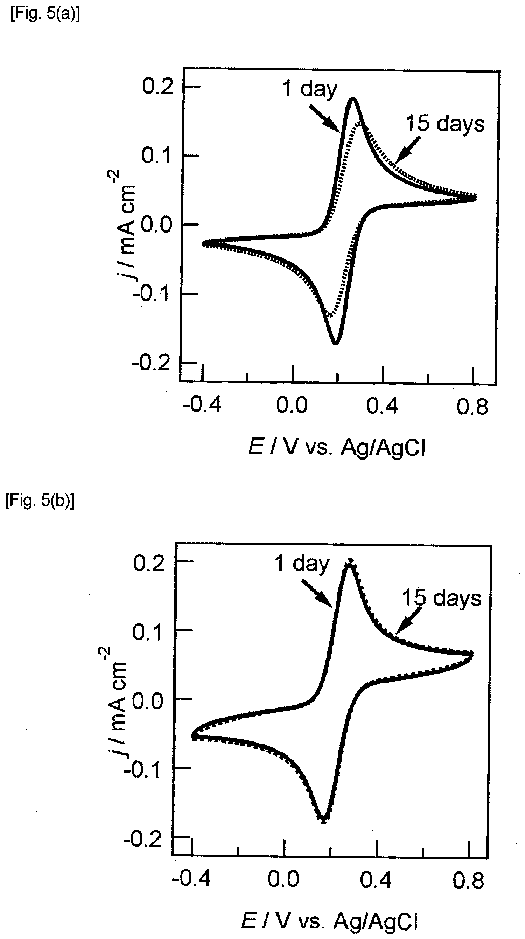

Fig. 5(a) shows cyclic voltammogram at 100mV/s of the polycrystalline conductive diamond layer without the carbon dioxide treatment, obtained in such a manner that the prepared electrode is cut out by 1 cm$^2$ to be used as anode without treatment, a platinum plate being used as a counter electrode, inter-electrode gap being 1cm, under room temperature, in 0.1 M sodium sulfate containing 1 mM ferri-/ferrocyanide ion couple.

Fig. 5(b) shows cyclic voltammogram at 100mV/s of the polycrystalline conductive diamond layer with micropore formed by the treatment method described in Example 1, in which the polycrystalline conductive diamond doped with boron on the surface of niobium substrate was treated for 4 hours at 800 degrees Celsius, while carbon dioxide is being supplied at a rate of 0.2 Umin. The measurement was obtained in 0.1 M sodium sulfate containing 1 mM ferri-/ferrocyanide ion couple. Oxidation-reduction peak width was 61 mV. Measurement which was made again with the sample left in air for 15 days showed no change in peak height and width, proving a high stability of the sample.

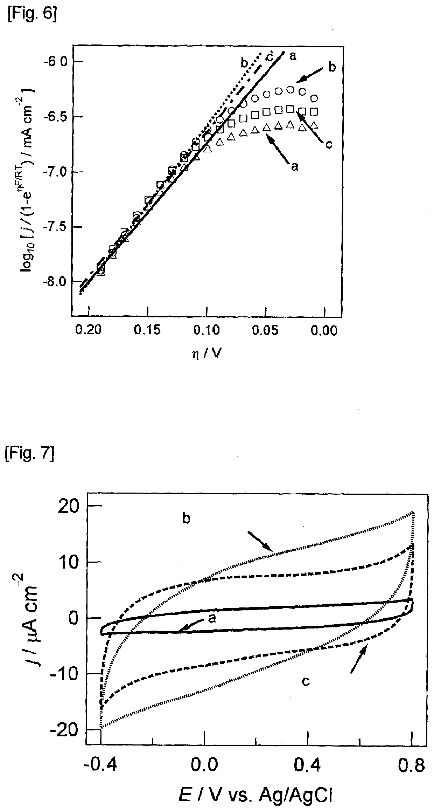

Fig. 6 shows current-potential curves, which represent relationship between current and overvoltage in the quasi-reversible reaction proposed by Allen-Hickling.

$$\log [i/(1-e^{f\eta})]= \log(i_0)-\alpha F\eta/(2.3RT)$$

Where, i is current density, e is the base of natural logarithm, $i_0$ is exchange current density, $\eta$ is overvoltage, $\alpha$ is the transfer coefficient of charge transfer reaction, F is Faraday constant, R is gas constant, T is the absolute temperature and f is F/RT.

The heterogeneous electron transfer coefficient of the polycrystalline conductive diamond layer treated by the method described in Example 1 was 0.008 cm s$^{-1}$ and the exchange current density $i_0$ was 7.6 $\mu$A, as shown by Line b.

The heterogeneous electron transfer coefficient of the electrode treated by the method described in Example 2 (Line c) was 0.002 cm s$^{-1}$ and the exchange current density $i_0$ increased to 5.1 $\mu$A.

As a result, the values of heterogeneous electron transfer coefficient of the polycrystalline conductive diamond layer of Line b and Line c indicating the electrodes treated by Example 1 and 2 show larger values than the value of heterogeneous electron transfer coefficient of the polycrystalline conductive diamond layer of Line a indicating the untreated electrode, proving that the polycrystalline conductive diamond electrode after treatment by Example 1 and Example 2 achieves high quality and high activity.

Fig. 7 shows cyclic voltammogram at 100mV/s in 0.1M sodium sulfate. Line b indicating the electrode treated by Example 1 increased by approx. 4 times and Line c indicating the electrode treated by Example 2 increased by approx. 3 times in electric double layer capacity compared with Line a indicating the untreated electrode.

[Comparative Example 1]

The electrode for electrochemistry was prepared as with Example 1 except micropore formation carried out in Example 1. The surface condition is as shown by the electron microscope photograph in Fig. 1. From the electron microscope photograph before the carbon dioxide treatment in Fig. 1, microcrystal structures of (100) plane which is cube orientation and (111) plane which is octahedron orientation were confirmed, with mainly of 1 - 2 $\mu$m order. Micropore has not been formed.

In the cyclic voltammogram in 0.1 M sodium sulfate containing ferri-/ferrocyanide ion couple, the initial peak width was 61 mV as shown in Fig. 5 (a), but after 15 days left in air, it increased to 116mV, showing irreversible response. The surface of untreated diamond electrode was oxidized in 15 days left as it was and became inactivated.

The heterogeneous electron transfer coefficient of ferri-/ferrocyanide ion couple and the exchange current density $i_0$ were 0.002 cm s$^{-1}$ and 3.6 $\mu$A, respectively, as shown in Fig. 6 by Line a.

[Example 3]

The solution of butyl alcohol and hydrochloric acid mixture prepared by mixing iridium chloride and butyl tantalate in a metal molar ratio of 2:1 was prepared as catalyst precursor solution. The catalyst precursor solution was coated on the niobium plate on which diamond layer is formed with the carbon dioxide treatment as with Example1. Then, the plate was dried and treated for thermal decomposition at 500 degrees Celsius for 10 minutes in circulation air. This operation was repeated 5 times to coat the electrode substance at a 0.04 mol/m$^2$ as iridium. Thus prepared electrode was cut out by 1cm$^2$ and using this as anode, electrolysis was carried out at 60 degrees Celsius under the conditions that the counter electrode was zirconium plate, inter-electrode gap was 1cm, and sulfuric acid was at 150 g/L. The cell voltage was maintained stably at a current density of 5 A/cm$^2$ for 1600 hours, proving that the electrode can be serviceable for a long time.

[Comparative Example 2]

The electrode with catalyst layer prepared in the same manner with Example 3 except that carbon dioxide treatment of the polycrystalline conductive diamond layer was not performed in Comparative Example 2. Using this electrode, electrolysis was carried out. With the lapse of 500 hours, the catalyst layer coating started to fall off, suggesting corrosion of electrode substrate, and electrolysis could not continue.

**Industrial Applicability**

The electrode for electrochemistry can be desirably applied, the use of which is not limited in particular, in various electrolyses including various plating processes, such as high speed galvanizing, metal electrowinning like electrolytic copper foil production, brine electrolysis, organic electrolysis, ozone production, water treatment, molten salt electrolysis, fuel cells, and sensors.

**Claims**

1. A manufacturing method for an electrode for electrochemistry, comprising the steps of:

   (1) forming a polycrystalline boron-doped conductive diamond layer on an electrode substrate chosen from carbon, titanium, tantalum and niobium,
   (2) holding the electrode substrate with the formed polycrystalline conductive boron-doped diamond layer under an atmosphere of carbon dioxide at a temperature 400 degrees Celsius or higher but 1000 degrees Celsius or lower, thereby forming micropores to (100) plane of said polycrystalline boron-doped conductive diamond layer.

2. The manufacturing method for the electrode for electrochemistry as in Claim 1, wherein a catalyst layer of electrode substance comprising platinum group metal and/or its oxides is formed in and on the polycrystalline conductive boron-doped diamond layer with the micropores formed to the (100) plane.

3. The manufacturing method for the electrode for electrochemistry as in Claim 1 or 2, wherein the typical diameter of the micropores is 1 nm or longer but 1$\mu$m or shorter.

**Patentansprüche**

1. Herstellungsverfahren für eine Elektrode für Elektrochemie, umfassend die Schritte:

    (1) Ausbilden einer polykristallinen Bor-gedopten leitfähigen Diamantschicht auf einem Elektrodensubstrat ausgewählt aus Kohlenstoff, Titan, Tantal und Niob,
    (2) Halten des Elektrodensubstrats mit der ausgebildeten Bor-gedopten leitfähigen Diamantschicht unter einer Atmosphäre von Kohlendioxid bei einer Temperatur von 400° Celsius oder höher, jedoch 1000° Celsius oder niedriger, wodurch Mikroporen auf der (100) Ebene der polykristallinen Bor-gedopten leitfähigen Diamantschicht gebildet werden.

2. Das Herstellungsverfahren für die Elektrode für Elektrochemie gemäß Anspruch 1, wobei eine Katalysatorschicht aus Elektrodensubstanz umfassend ein Platingruppenmetall und/oder deren Oxiden in und auf der polykristallinen Bor-gedopten leitfähigen Diamantschicht mit den auf der (100) Ebene ausgebildeten Mikroporen gebildet wird.

3. Das Herstellungsverfahren für die Elektrode für Elektrochemie gemäß Anspruch 1 oder 2, wobei der typische Durchmesser der Mikroporen 1 nm oder länger, jedoch 1 $\mu$m oder kürzer ist.


**Revendications**

1. Procédé de fabrication d'une électrode pour électrochimie, comprenant les étapes consistant à :

    (1) former une couche de diamant conducteur dopé au bore polycristallin sur un substrat d'électrode choisi parmi le carbone, le titane, le tantale et le niobium,
    (2) maintenir le substrat d'électrode avec la couche de diamant dopé au bore conducteur polycristallin formée dans une atmosphère de dioxyde de carbone à une température de 400 degrés Celsius ou plus mais de 1000 degrés Celsius ou moins, en formant ainsi des micropores vers le plan (100) de ladite couche de diamant conducteur dopé au bore polycristallin.

2. Procédé de fabrication d'une électrode pour électrochimie selon la revendication 1, dans lequel une couche de catalyseur de substance d'électrode comprenant un métal du groupe du platine et/ou ses oxydes est formée dans et sur la couche de diamant dopé au bore conducteur polycristallin avec des micropores formés vers le plan (100).

3. Procédé de fabrication d'une électrode pour électrochimie selon la revendication 1 ou 2, dans lequel le diamètre typique des micropores est de 1 nm ou plus mais de 1 $\mu$m ou moins.

[Fig. 1]

600 nm

[Fig. 2]

600 nm

[Fig. 3]

600 nm

[Fig. 4]

[Fig. 5(a)]

[Fig. 5(b)]

[Fig. 6]

[Fig. 7]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 58160860 A
- JP 7299467 A
- JP 2000226682 A
- JP 2000254650 A
- JP 11269685 A
- JP 3893397 B
- JP 2006183102 A
- JP 2761751 B
- JP 2574699 B
- JP 9279398 A
- JP 2007242433 A
- JP 2011184749 A

**Non-patent literature cited in the description**

- *Journal of Electrochemical Society,* 1994, vol. 141, 3382
- *Electrochemistry,* 1999, vol. 67 (4), 389
- *Adv. Mater.,* 2000, vol. 6, 444
- *J. Electroanal. Chem.,* 2001, vol. 514, 35
- *Electrochimica Acta, 2011,* 2011, vol. 56, 5599
- *Diamond Rel. Mater,* 1998, vol. 7, 1719